(19) Europäisches Patentamt
European Patent Office
Office européen des brevets

(11) Publication number: **0 035 530**
**B1**

(12) **EUROPEAN PATENT SPECIFICATION**

(45) Date of publication of patent specification: **23.10.85**

(51) Int. Cl.⁴: **G 03 C 11/12,** G 03 C 1/78, G 03 C 1/68

(21) Application number: **80901739.5**

(22) Date of filing: **28.07.80**

(86) International application number: **PCT/US80/00948**

(87) International publication number: **WO 81/00627 05.03.81 Gazette 81/06**

(54) **IMAGEABLE, COMPOSITE DRY-TRANSFER SHEET.**

(30) Priority: **17.08.79 US 67322**
**19.06.80 US 158951**

(43) Date of publication of application: **16.09.81 Bulletin 81/37**

(45) Publication of the grant of the patent: **23.10.85 Bulletin 85/43**

(84) Designated Contracting States: **DE FR GB**

(56) References cited:
**DE-A-2 342 687**
**US-A-3 353 955**
**US-A-3 627 529**
**US-A-3 770 438**
**US-A-4 026 705**
**US-A-4 050 936**
**US-A-4 090 936**
**US-A-4 161 405**

(73) Proprietor: **MINNESOTA MINING AND MANUFACTURING COMPANY**
**3M Center, P.O. Box 33427**
**St. Paul, MN 55133 (US)**

(72) Inventor: **BERGGREN, William R.**
**P.O. Box 33427**
**St. Paul, MN 55133 (US)**
Inventor: **BROWNLEY, Shelby J.**
**P.O. Box 33427**
**St. Paul, MN 55133 (US)**

(74) Representative: **Baillie, Iain Cameron et al**
**c/o Ladas & Parry Isartorplatz 5**
**D-8000 München 2 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

EP 0 035 530 B1

Courier Press, Leamington Spa, England.

## Description

*Technical Field*

The present invention relates to image production and transfer. More particularly it relates to imageable composite dry-transfer sheets and their method of use.

In the present invention, an image is produced by exposing the composite dry-transfer sheet to activating radiation, e.g., ultraviolet light, in an image-wise manner. The image is then transferred to a suitable surface by burnishing (i.e., the application of pressure to the backside of the transfer sheet in the image areas). To be transferable in this manner, the image must have a stronger affinity for the receptor surface than for the substrate surface after burnishing. Additionally, the image must possess sufficient cohesive strength (i.e., film character) so that it transfers completely from the substrate to the receptor after burnishing even though pressure may not have been applied evenly to all parts of the image.

Pressure transfer of images from a substrate to a receptor has been previously described. For example, U.S. Patent 3,013,917 describes sheets that contain ink designs in the form of characters. A wax coating is provided on the characters so as to make them pressure-transferable (i.e., burnishable). These sheets have not proven totally satisfactory, however, as it is necessary to maintain a large inventory of them in order to have sufficient quantities of all characters on hand. Moreover, non-standard characters are difficult to obtain and typically substantial lead times are required in order to make them available.

Sheets that employ photopolymerizable layers for the formation of images that are then transferable by dry transfer techniques are also known. Thus, see British Patent 1,521,766 and U.S. Patent 4,041,204. The photopolymerizable layer of these sheets must be image-wise exposed to activating radiation. The images are then developed by washing away the unexposed areas of the photopolymerizable layer. The exposed areas may then be burnished. These sheets are inconvenient to use because they require special developing equipment and solutions in order to wash away the unexposed areas of the photopolymerizable layer.

Still other photopolymerizable, image forming sheets are described in U.S. Patent 4,081,282. However, a pressure-sensitive adhesive layer must be applied to the formed images of these sheets before they can be burnished.

U.S. Patent 3,754,920 describes a sheet wherein the photopolymerizable layer utilizes a free radically polymerizable ethylenically unsaturated monomer. The photopolymerizable layer is situated between a support and a cover layer. After these sheets are image-wise exposed to activating radiation, the support and cover layers are separated from the photopolymerizable layer. The unexposed portions of the photopolymerizable layer are said to be burnishable onto a receptor. However, the transfer of these unexposed portions cleanly and with high resolution is difficult to achieve.

U.S. Patent 3,353,955 describes certain photopolymerizable laminated elements wherein a photopolymerizable layer is laminated between one transparent support layer and a second support having a matte finish. The lamination is effected at at least 50°C by exposing the photopolymerizable element to actinic radiation through the transparent support and separating the supports by peeling them apart at ambient temperature to obtain a positive and negative image.

U.S. Patent 4,090,936 describes photohardenable liquid compositions useful as plating and etching resists. The compositions described include an organic expoxide, an organic polymer compatible with the epoxide comprising either an acrylic or methacrylic monomer, a styrene/allyl alcohol co-polymer or a polyvinyl butyral polymer and an aromatic complex salt photoinitiator which is an 'onion salt of a group V B or VI B element or an aromatic halonium salt.

The present invention overcomes these disadvantages. It provides an imageable composite sheet material which permits the formation and ready transfer of images to a variety of receptors in a completely dry process. Consequently, the present invention permits the formation and transfer of images with conventional techniques thereby permitting simple and economical utilization.

The present invention also permits the user to form the desired characters from a variety of original sources such as hand drawn masters, pre-printed masters, photographic positives, etc., and then transfer them to a receptor. This eliminates the need to maintain a large inventory of sheets bearing preformed characters. It also gives the user great flexibility in the design of the characters to be transferred. The present invention also utilizes a photopolymerizable material whose polymerization is not inhibited by oxygen. Consequently, unexposed image areas can readily be either partially or completely polymerized if desired. Still other advantages of the present invention will be described hereinafter.

The imageable, composite dry-transfer sheets of the present invention may be employed in a number of ways. For example, they may be used as Do-It-Yourself transfer letter sheets. Alternatively, they may be used to form and then apply decorative or informative decals to receptors that include glass and metal. Still further, they may be used to form burnishable images from artwork (e.g., pictures, drawings, etc.) that may subsequently be transferred to receptors.

---

Note: In this specification are used various commercial names. Many of these are registered trade marks in one or more countries, but these materials are mainly listed as common commercial materials illustrative of the materials which can be used.

Other methods of use are also possible. Thus, the sheets of the invention may be used to make silk screen stencils and dry printing plates.

*Disclosure of Invention*

In accordance with the present invention there is provided an imageable composite dry-transfer sheet that comprises (a) a cover sheet that is transmissive to activating radiation and has at least one oleophilic surface, (b) a photopolymerizable layer on the oleophilic surface of said cover sheet that comprises a cationically polymerizable organic material, and from about 0.1 to 10 parts by weight per 100 parts by weight of said organic material of a cationic polymerization initiator, and optionally, from about 1 to 100 parts by weight per 100 parts by weight of said organic material of a thermoplastic hydrocarbon resin that has a ring and ball softening point of more than about 100°C and is chemically inert to said organic material and said initiator, and (c) a base sheet that has an oleophobic surface in contact with said photopolymerizable layer;

wherein said photopolymerizable layer has a complex shear modulus of, at most, 5.054 Pa ($1 \times 10^6$ dynes/$cm^2$); and

wherein, after image-wise exposure to activating radiation, the interfacial adhesion of the unexposed areas of said layer is greater for said cover sheet than for said base sheet; the interfacial adhesion of the exposed areas of said layer is greater for said base sheet than for said cover sheet; and

wherein, after separation of said cover and said base sheets, the unexposed areas of said layer are rendered burnishable by subsequent exposure to activating radiation through said cover sheet.

The present invention combines peel-apart development and burnish transferability (burnishability) in achieving the foregoing results. These properties are the result of different interfacial adhesions of the base and cover sheets for the photopolymerizable layer. Thus, the photopolymerizable layer adheres more strongly to the cover sheet than to the base sheet prior to exposure to activating radiation. However, after the photopolymerizable layer has been exposed to activating radiation through the cover sheet, the now photopolymerized layer adheres more strongly to the base sheet than to the cover sheet. Consequently, when the photopolymerizable layer is exposed to activating radiation in an image-wise manner through the cover sheet, and the cover and base sheets are peeled apart, the exposed areas adhere to the base sheet and the unexposed areas adhere to the cover sheet.

The photopolymerizable layer demonstrates the following additional properties after image-wise exposure of the sheets to activating radiation:

a) The cohesive strength of the unexposed areas of the layer is greater than the strength of the adhesion of these areas to the base sheet.

b) The cohesive strength of the unexposed areas is less than, or equal to, the adhesion of these areas to the cover sheet.

c) The photopolymerizable layer has sufficient vertical cohesion and frangibility to fracture cleanly at the boundary between the exposed and unexposed areas.

After the sheets of the invention have been image-wise exposed and peeled apart, the unexposed areas are rendered burnishable by being exposed to activating radiation through the cover layer or sheet. The now-burnishable areas possess sufficient cohesive strength, as opposed to particulate character, so that they transfer completely to the desired receptor even though not all of the coating has been subjected to the same degree of burnishing pressure.

The areas to be transferred also possess a balanced adhesion/cohesion so that they transfer completely to the receptor.

The foregoing characteristics of the invention are the result of the complex shear modulus of the photopolymerizable layer. Thus, it has been found that if the complex shear modulus exceeds 5.05 Pa ($1 \times 10^6$ dyne/$cm^2$), both the unexposed and exposed areas of the photopolymerizable layer adhere more strongly to the base sheet than to the cover sheet. Consequently, when the cover and base sheets are peeled apart, there is nothing transferred to the cover sheet.

The complex shear modulus may be measured according to the procedures described in "Viscoelastic Properties of Polymers", J. D. Ferry, 2d. Ed., John Wiley & Sons, N.Y. (1970) at pages 121—124.

*Brief Description of Drawings*

The present invention is described in more detail hereinafter with reference to the accompanying drawings wherein like reference characters refer to the same elements throughout the several views and wherein

Figure 1 shows an edge view of an imageable, composite dry-transfer sheet according to the invention;

Figure 2 shows an edge view of the sheet of Figure 1 in contact with a graphic original being exposed through the original to activating radiation;

Figure 3 shows the exposed sheet of Figure 2 being peeled apart;

Figure 4 shows the previously unexposed portions of the sheet of Figure 3 being subjected to activating radiation.

Figure 5 shows the exposed sheet of Figure 4 placed on a receptor and being burnished;

Figure 6 shows the backing of the sheet of Figure 4 being removed from the burnished images so that the images transfer to the receptor.

*Detailed Description*

The cover sheet of the present invention must be transmissive to the activating radiation. While it may be oleophilic per se, it need have only one oleophilic surface for contact with the photopolymerizable layer. Thus, it may comprise a composite material that is made up of an oleophobic material that has been rendered oleophilic on at least one surface by coating or other surface treatment.

Examples of materials which are oleophilic per se, or which may be rendered oleophilic, and which are, therefore, useful as the cover sheet include certain polyester sheeting, cellulose acetate sheeting, polypropylene sheeting, polyethylene sheeting, vinyl chloride sheeting, etc.

The base sheet may be either transmissive or opaque to the activating radiation and must possess at least one oleophobic surface for contact with the photopolymerizable layer. Consequently, it may either be oleophobic per se or possess an oleophobic surface. Examples of materials useful as the base sheet include metal sheets and foils, polyester, cellulose acetate, etc.

Cationically polymerizable organic materials useful in the photopolymerizable layer include polymerizable epoxide-containing and vinyl ether-containing materials. These materials undergo cationically induced polymerization to yield higher molecular weight products. They may be of the monomeric or polymeric type and can be aliphatic, cycloaliphatic, aromatic or heterocyclic.

Useful epoxide-containing materials (hereinafter epoxides) are those having an average epoxide functionality of at least one. The epoxide functionality refers to an oxirane ring

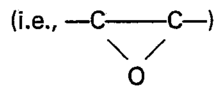

that is polymerizable by a cationically induced ring opening mechanism. Preferably the epoxides have an average epoxide functionality of at least two. The average epoxide functionality is determined by dividing the total number of epoxy groups in the epoxide by the total number of molecules of the epoxide.

Polymeric epoxides useful in the invention include linear polymers having terminal epoxy groups (e.g., diglycidyl ether of a polyoxyalkylene glycol), polymers having skeletal oxirane units (e.g., polybutadiene polyepoxide), and polymers having pendent epoxy groups (e.g., a glycidyl methacrylate polymer or copolymer). The epoxides may be pure compounds but are generally mixtures containing one, two, or more epoxy groups per molecule.

The epoxides may vary from low molecular weight monomeric materials to high molecular weight polymers and may vary greatly in the nature of their backbone and the substituent groups. For example, the backbone may be of any type and the substituent groups can be any group free of an active hydrogen atom which is reactive with an oxirane ring at room temperature. Illustrative of permissible substituent groups are halogens, ester groups, ether groups, sulfonate groups, siloxane groups, nitro groups, phosphate groups, etc. The molecular weight of the epoxides may vary from 58 to about 100,000 or more. Mixtures of various epoxides can be used in the compositions of this invention.

Examples of useful epoxides include those which contain cyclohexane oxide groups, such as the epoxycyclohexanecarboxylates typified by 3,4-epoxycyclohexylmethyl-3,4-epoxycyclohexanecarboxylate; 3,4-epoxy-2-methylcyclohexylmethyl-3,4-epoxy-2-methylcyclohexane carboxylate; and bis(3,4-epoxy-6-methylcyclohexylmethyl) adipate. For a more detailed list of useful epoxides of this nature, reference is made to the U.S. Patent No. 3,117,099.

Other epoxides which are useful in the practice of this invention include glycidyl ether monomers of the formula

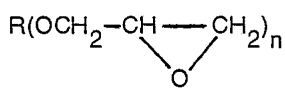

where R is alkyl or aryl and n is an integer of 1 to 6. Examples of these epoxides include the glycidyl ethers of polyhydric phenols obtained by reacting a polyhydric phenol with an excess of chlorohydrin such as epichlorohydrin (e.g., the diglycidyl ether of 2,2-bis-(2,3-epoxypropoxyphenol)propane). Further examples of epoxides of this type which can be used in the practice of this invention are described in U.S. Patent No. 3,018,262 and in "Handbook of Epoxy Resins" by Lee and Neville, McGraw-Hill Book Company, New York (1967).

There are many commercially available epoxides which can be used in this invention. In particular, such expoxides include octadecylene oxide, epichlorohydrin, styrene oxide, vinyl cyclohexene dioxide, glycidol, glycidyl methacrylate, diglycidyl ether of Bisphenol A (e.g., those available under the trade designations (See note below). "Epon 828", "Epon 1004" and "Epon 1010" from Shell Chemical Company, "DER—331", "DER—332", and "DER—334", from Dow Chemical Company, vinylcyclohexene dioxide (e.g., "ERL—4206" from Union Carbide Corporation), 3,4-epoxycyclohexylmethyl-3,4-epoxycyclohexane carboxylate (e.g., "ERL—4221" from Union Carbide Corporation), 3,4-epoxy-6-methylcyclohexylmethyl-3,4-epoxy-6-methylcyclohexane carboxylate (e.g. "ERL—4021" from Union Carbide Corporation), bis(3,4-epoxy-6-methylcyclohexylmethyl) adipate (e.g., "ERL—4299" from Union Carbide Corporation), bis(2,3-epoxycyclopentyl) ether (e.g., "ERL—0400" from Union Carbide Corporation), aliphatic epoxy modified

with polypropylene glycol (e.g., "ERL-4050" from Union Carbide Corporation), dipentene dioxide (e.g., "ERL—4269" from Union Carbide Corporation), epoxidized polybutadiene (e.g. "oxiron 2001" from FMC Corporation), silicone resin containing epoxy functionality, flame retardant epoxy resins (e.g. "DER—580", a brominated bisphenol type epoxy resin available from Dow Chemical Company), 1,4-butanediol diglycidyl ether of phenolformaldehyde novolak (e.g., "DEN—431" and "DEN—438" from Dow Chemical Company) and resorcinol diglycidyl ether (e.g., "Kopoxite" from Koppers Company Incorp).

Still other useful epoxides are copolymers of acrylic acid esters of glycidol such as glycidyl acrylate and glycidyl methacrylate with one or more copolymerizable vinyl compounds. Examples of such copolymers are 1:1 styrene:glycidyl methacrylate, 1:1 methyl methacrylate:glycidyl acrylate and a 62.5:24:13.5 methyl methacrylate:ethyl acrylate:glycidyl methacrylate terpolymer.

Other useful epoxides are well known and include epichlorohydrins, e.g., epichlorohydrin; alkene oxides, e.g., propylene oxide, styrene oxide; alkenyl oxides, e.g., butadiene dioxide; and glycidyl esters, e.g., ethyl glycidate.

Useful vinyl ether-containing materials (hereinafter vinyl ethers) are those containing at least one vinyl ether group (i.e., $CH_2{=}CHO$—). These materials are known and include the alkyl vinyl ethers represented by the formula $(H_2C{=}CHO)_mR^9$ wherein m is an integer of 1 to 4 and $R^9$ is an organic group (either polymeric or low molecular weight) that is free from groups that are reactive with the vinyl ether group. Representative of useful vinyl ethers is divinyl ether of diethylene glycol.

Combinations of two or more vinyl ethers are useful in the present invention as are combinations of epoxides with vinyl ethers.

Cationic photopolymerizable initiators useful in polymerizing the epoxides and vinyl ethers include aromatic iodonium and sulfonium complex salts. Halogen-containing organic compounds are also useful as cationic polymerization initiators for the vinyl ethers. The initiators comprise from about 0.1 to 10 parts by weight per 100 parts by weight of the cationically polymerizable organic material. Preferably they comprise from about 0.5 to 7 parts by weight. The exact quantity of initiator employed is influenced by the polymerizable material and the initiator utilized, and the transmissivity of the polymerizable layer to activating radiation.

Useful aromatic iodonium and sulfonium complex salts have formulae selected from

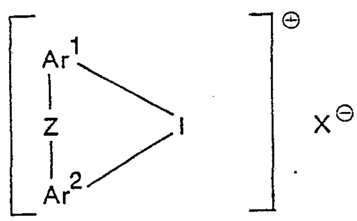

(A)

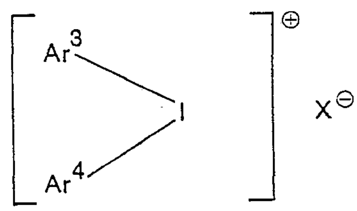

(B)

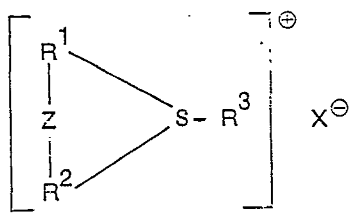

(C)

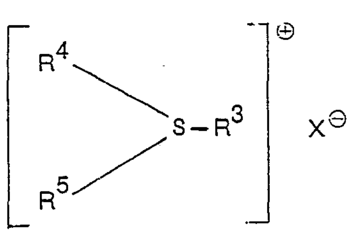

(D)

In these formulae $Ar^1$ and $Ar^2$ are the same or different substituted or unsubstituted divalent aromatic groups that have from about 6 to 20 carbon atoms; $Ar^3$ and $Ar^4$ are the same or different substituted or

unsubstituted monovalent aromatic groups that have from about 6 to 20 carbon atoms; $R^1$ and $R^2$ are selected from substituted and unsubstituted divalent aromatic groups that contain from about 6 to 20 carbon atoms and substituted or unsubstituted alkylene groups that contain from about 1 to about 20 carbon atoms; and $R^3$, $R^4$ and $R^5$ are each selected from substituted and unsubstituted monovalent aromatic groups that contain from about 6 to 20 carbon atoms and substituted and unsubstituted alkyl groups that contain from 1 to 20 carbon atoms, provided that at least one of the $R^1$ through $R^5$ groups is aromatic. Preferably, each of the $R^1$ through $R^5$ groups is aromatic.

In formulae A and C, Z is selected from a carbon-to-carbon bond; oxygen, sulfur, S=O, C=O, O=S=O, $R^6$—N wherein $R^6$ is aryl or acyl, $R^7$—C—$R^8$ wherein $R^7$ and $R^8$ are selected from hydrogen, alkyl groups that contain from about 1 to 4 carbon atoms, and alkenyl groups that contain from about 2 to 4 carbon atoms.

In all formulae X is a halogen-containing complex anion.

Representative examples of useful $Ar^1$, $Ar^2$ and aromatic $R^1$ and $R^2$ groups include phenylene, thienylene, furanylene, and pyrazolylene groups.

Representative examples of useful $Ar^3$, $Ar^4$ and aromatic $R^3$, $R^4$ and $R^5$ groups include phenyl, thienyl, furanyl, and pyrazol groups.

The divalent and monovalent groups may also have one or more fused benzo rings (e.g., naphthyl, naphthylene and the like; benzothienyl, benzothienylene, benzofuranyl, benzofuranylene, dibenzofuranyl, etc.). The divalent and monovalent aromatic groups may also be substituted, if desired, by one or more of the following groups: halogen, nitro, hydroxyl, ester groups (e.g., alkoxycarboxyl such as methoxycarbonyl and ethoxycarbonyl, phenoxycarbonyl and acyloxy such as acetoxy and propionyloxy), sulfo ester groups (e.g., alkoxysulfonyl such as methoxysulfonyl and butoxysulfonyl, phenoxysulfonyl, and the like), alkoxy groups (e.g., methoxy, ethoxy, butoxy, and the like), aryl groups (e.g., phenyl), alkyl groups (e.g., phenoxy), thioaryloxy groups (e.g., thiophenoxy), alkylsulfonyl (e.g., methylsulfonyl, ethylsulfonyl, and the like), arylsulfonyl groups (e.g., phenylsulfonyl groups), perfluoroalkyl groups (e.g., trifluoromethyl, perfluoroethyl, and the like), and perfluoroalkylsulfonyl groups (e.g., trifluoromethylsulfonyl, perfluorobutylsulfonyl, and the like).

Halogen-containing anions (X) useful in the invention include tetrafluoroborate, hexafluoroarsenate, hexafluorophosphate and hexafluoroantimonate.

The aromatic iodonium cations are known and recognized in the art. See for example, U.S. Patents 3,565,906; 3,712,920; 3,759,989; and 3,763,187; F. Beringer, et al., Diaryliodonium Salts IX, J. Am. Chem. Soc. 81, 342—51 (1959) and F. Beringer, et al., Diaryliodonium Salts XXIII, J. Chem. Soc. 1964, 442—51; F. Beringer, et al., Iodonium Salts Containing Heterocyclic Iodine, J. Org. Chem., 30 1141—8 (1965).

Representative examples of useful aromatic iodonium complex salts include

diphenyliodonium tetrafluoroborate
di(4-methylphenyl)iodonium tetrafluoroborate
phenyl-4-methylphenyliodonium tetrafluoroborate
di(4-heptylphenyl)iodonium tetrafluoroborate
di(3-nitrophenyl)iodonium hexafluorophosphate
di(4-chlorophenyl)iodonium hexafluorophosphate
di(naphthyl)iodonium tetrafluoroborate
di(4-trifluoromethylphenyl)iodonium tetrafluoroborate
diphenyliodonium hexafluorophosphate
di(4-methylphenyl)iodonium hexafluorophosphate
diphenyliodonium hexafluoroarsenate
di(4-phenoxyphenyl)iodonium tetrafluoroborate
phenyl-2-thienyliodonium hexafluorophosphate
3,5-dimethylpyrazolyl-4-phenyliodonium hexafluorophosphate
bis-(2,4-dimethylphenyl)iodonium hexafluoroantimonate
diphenyliodonium hexafluoroantimonate
2'2-diphenyliodonium tetrafluoroborate
di(2,4-dichlorophenyl)iodonium hexafluorophosphate
di(4-bromophenyl)iodonium hexafluorophosphate
di(4-methoxyphenyl)iodonium hexafluorophosphate
di(3-methoxycarbonylphenyl)iodonium hexafluorophosphate
di(3-methoxysulfonylphenyl)iodonium hexafluorophosphate
di(2-benzothienyl)iodonium hexafluorophosphate

The aromatic iodonium complex salts preferred in the present invention are the diaryliodonium hexafluorophosphate and the diaryliodonium hexafluoroantimonate salts.

The aromatic iodonium complex salts may be prepared by metathesis of corresponding aromatic iodonium simple salts (such as, for example, the diphenyliodonium bisulfate) in accordance with the teachings of Beringer et al., J. Am. Chem. Soc. 81, 342 (1959). Alternatively, they may be prepared in accordance with Beringer et al., above, by various methods including (1) coupling of two aromatic compounds with iodyl sulfate in sulfuric acid, (2) coupling of two aromatic compounds with an iodate in

acetic acid-acetic anhydride-sulfuric acid, (3) coupling of two aromatic compounds with an iodine acylate in the presence of an acid, and (4) condensation of an iodoso compound, an iodoso diacetate, or an iodoxy compound with another aromatic compound in the presence of an acid.

More specifically, aromatic iodonium complex salts may be prepared by reacting an appropriate aromatic iodine salt (e.g., 316.5 g $\phi_2I^+Cl^-$) with a desired complex salt (e.g., 252.8 g $AgPF_6$) in a polar solvent such as methyl alcohol. Reaction may be conveniently carried out at room temperature.

Aromatic sulfonium salts are known and recognized in the art. Triaryl-substituted sulfonium compounds, for example, can be prepared by the procedures described in G. H. Wiegand, et al., Synthesis and Reactions of Triaryl-sulfonium Halides, J. Org. Chem. *33*, 2671—75 (1968). Aromatic sulfonium salts also having alkyl-substitution can be prepared by the procedures described in K. Ohkubo et al., J. Org. Chem. *36*, 3149—55 (1971). Yet another method for making triaryl-substituted sulfonium compounds is described in U.S. 2,807,648, from which the complex sulfonium salts can be made. The complex sulfonium salts can be prepared from the corresponding simple salts, such as the halide salts, by metathesis with a metal or ammonium salt of the complex anion desired.

Examples of useful aromatic sulfonium complex salt photoinitiators include:

triphenylsulfonium tetrafluoroborate
methyldiphenylsulfonium tetrafluoroborate
dimethylphenylsulfonium hexafluorophosphate
triphenylsulfonium hexafluorophosphate
triphenylsulfonium hexafluoroantimonate
triphenylsulfonium hexafluoroarsenate
diphenylnaphthylsulfonium hexafluoroarsenate
triphenylsulfonium hexafluoroarsenate
tritolysulfonium hexafluorophosphate
anisyldiphenylsulfonium hexafluoroantimonate
4-butoxyphenyldiphenylsulfonium tetrafluoroborate
4-chlorophenyldiphenylsulfonium hexafluoroantimonate
4-chlorophenyldiphenylsulfonium hexafluoroarsenate
tris(4-phenoxyphenyl)sulfonium hexafluorophosphate
di(4-ethoxyphenyl)methylsulfonium hexafluoroarsenate
4-acetoxy-phenyldiphenylsulfonium tetrafluoroborate
tris(4-thiomethoxyphenyl)sulfonium hexafluorophosphate
di(methoxysulfonylphenyl)methylsulfonium hexafluoroantimonate
di(methoxynaphthyl)methylsulfonium tetrafluoroborate
4-phenylthiophenyldiphenylsulfonium hexafluoroantimonate
4-phenylthiophenyldiphenylsulfonium hexafluoroarsenate
di(carbomethoxyphenyl)methylsulfonium hexafluorophosphate
dimethylnaphthylsulfonium hexafluorophosphate
trifluoromethyldiphenylsulfonium tetrafluoroborate
methyl(N-methylphenothiazinyl)sulfonium hexafluoroantimonate
phenylmethylbenzylsulfonium hexafluorophosphate

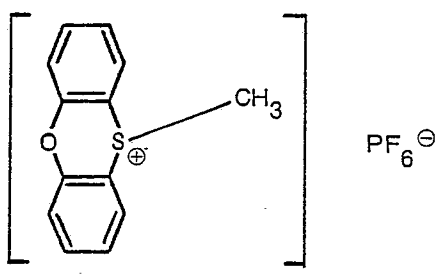

(10-methylphenoxathiinium hexafluorophosphate)

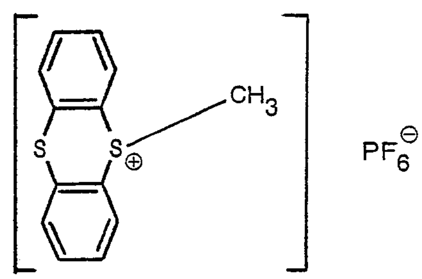

(5-methylthianthrenium hexafluorophosphate)

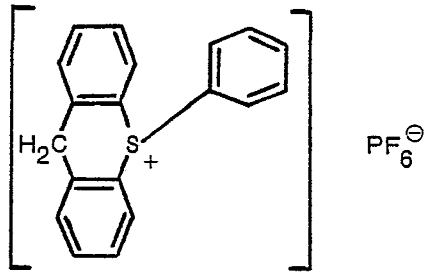

(10-phenylthioxanthenium hexafluorophosphate)

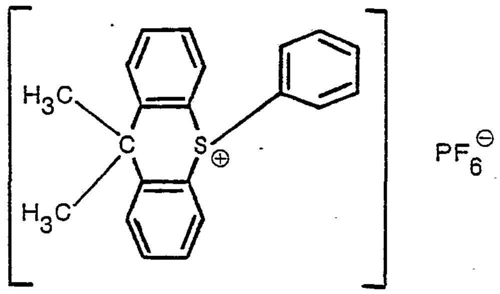

(10-phenyl-9,9-dimethylthioxanthenium hexafluorophosphate)

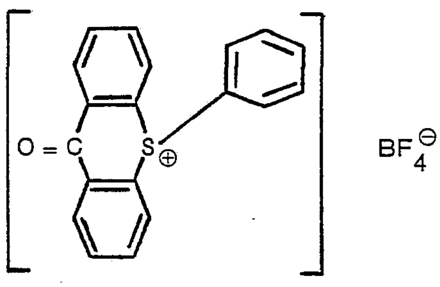

(10-phenyl-9-oxothioxanthenium tetrafluoroborate)

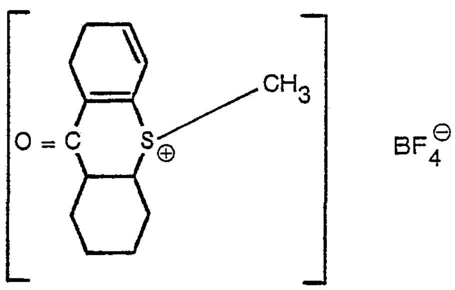

(5-methyl-10-oxothianthrenium tetrafluoroborate)

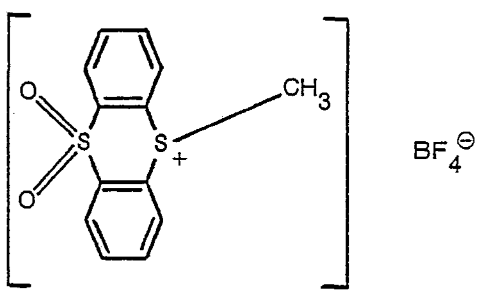

(5-methyl-10,10-dioxothianthrenium hexafluorophosphate)

Halogen-containing compounds useful as initiators in the present invention contain halogen attached to carbon. These compounds, upon exposure to radiation of suitable wavelength (i.e., 300—900 nanometers), dissociate and form halogen acids. The bond dissociation energy for the carbon-to-halogen bonds is in the range of about 40 to 70 kilogram calories per mole. They are, preferably, solid organic compounds which are neither strongly acidic nor strongly basic.

Examples of useful halogen-containing compounds include 1-methyl-3,5-bistrichloromethyl triazine, 1,3,5-tristrichloromethyl triazine, 1,3,5-tristribromoethyl triazine, hexabromoethane, carbon tetrabromide, α,α-dibromo-o-xylene.

Thermoplastic hydrocarbon resins useful in the present invention comprise from about 1 to 100 parts by weight per 100 parts by weight of the cationically polymerizable material. Preferably they comprise from about 10 to 40 parts, and most preferably about 20 parts, per 100 parts of the polymerizable material. These resins impart cohesive strength to the unexposed areas of the photopolymerizable layer.

Suitable thermoplastic resins have a ball and ring softening point of at least 100°C and are chemically inert to the cationically polymerizable organic material and the photopolymerization initiator in the absence of activating radiation. Additionally, they do not increase the cohesive nature of the unpolymerized photopolymerizable layer beyond the limits described above and do not alter the adhesion balance of the exposed and unexposed areas of the photopolymerizable layer to the base and cover sheets beyond the limits previously described.

Representative examples of useful thermoplastic resins include block copolymers, polyolefin resins, and acrylic resins. Representative examples of useful block copolymers are "Kraton 1101", a block copolymer having terminal blocks of styrene and central blocks of butadiene groups, and "Kraton 1650" having terminal blocks of styrene groups and central blocks of combinations of ethylene and butylene groups. The "Kraton" resins are available from Shell Chemical Company.

Representative examples of useful polyolefin resins include polystyrene resins such as "Piccolastic C125", a modified, low molecular weight resin produced largely from styrene monomer and having a ring and ball softening point in the range of 122—128°C, available from Hercules Incorporated; and "Styron 685", a polystyrene resin available from Dow Chemical Company.

Representative examples of useful acrylic resins include "Elvacite 2041" (a methyl methacrylate polymer, glass transition temperature of 95°C), available from Du Pont.

Various other ingredients may be included in the photopolymerizable layer of the present invention. For example, tackifying agents, plasticizing agents, sensitizers, colorants, fillers, viscosity modifiers, and so forth, may be included.

Tackifying agents typically comprise up to 200 parts by weight per 100 parts by weight of the organic cationically polymerizable material. Useful tackifying agents have a ring and ball softening point below about 100°C and preferably below about 60°C and include rosin and rosin derivatives, low molecular weight styrene resins, cyclohexanone resins, coumarone resins, indene resins, terpene resins, coumarone-indene resin, etc. Specific examples of useful tackifying resins include polystyrene such as "Piccolastic A" series of resins having ring and ball softening points below about 100°C such as A—25 (ring and ball softening point in the range of 24—27°C available from Hercules Chemical Company) and polymerized mixed olefins such as the "Sta-Tac" and "Super Sta-Tac" series of resins from Reichold Chemical Company. Other specific examples include "Foral 85", a hydrogenated ester resins available from Hercules Incorporated.

Representative examples of useful plasticizing agents are solid phthalate esters, e.g., dicyclohexylphthalate, and para-toluenesulfonamide and its derivatives, etc. Other materials that may be employed as plasticizing agents include heavy mineral oils such as "Drakeol 35" a white mineral oil available from Pennsylvania Refining Company; "Shellmax 500", a microcrystalline wax available from Shell Chemical Company and "Elvax 150", an ethylene/vinyl acetate copolymer available from Du Pont.

The use of tackifying resins and plasticizing agents in the present invention is particularly preferred. Thus, without at least one of these materials present in the photopolymerizable layer, the unphotopolymerized areas to be transferred can be only partially polymerized before burnishing. However, when either or both of these materials are present in the unphotopolymerized areas to be transferred, they can be completely polymerized before burnishing. These ingredients are apparently unaffected by exposure to the activating radiation. In any event, the images transferred are resistant to abrasion and smearing.

The photopolymerization initiators useful in the present invention are of themselves photosensitive only in the ultraviolet. They, however, can be sensitized to the near ultraviolet and the visible range of the spectrum by a variety of sensitizers. Typically, the sensitizers comprise up to about 10 parts by weight per 100 parts by weight of cationically polymerizable material.

Examples of useful sensitizers may be found in the following categories:

(1) Aromatic tertiary amines having the formula

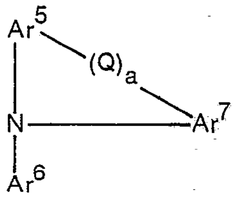

where $Ar^5$, $Ar^6$ and $Ar^7$ are aromatic groups having 6 to 20 carbon atoms and may be the same or different. The aromatic groups may be substituted, if desired, with groups or radicals such as hydroxyl, alkoxy, acyl or alkyl. Q may be oxygen; sulfur; S=O; C=O; O=S=O; $R^9$—N where $R^9$ is aryl (of 6 to 20 carbons, such as phenyl, naphthyl, etc.); a carbon-to-carbon bond; or $R^7$—C—$R^8$, where $R^7$ and $R^8$ are selected from hydrogen, alkyl radicals of 1 to 4 carbons, and alkenyl radicals of 2 to 4 carbons, and wherein a is zero or 1.

(2) Aromatic tertiary diamines having the formula

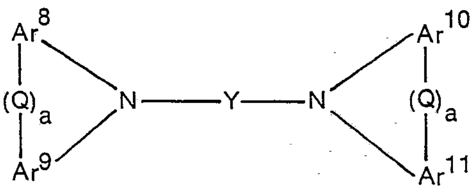

where Y is a divalent radical selected from arylene and $Ar^{12}$—Z—$Ar^{13}$, where Q is as described above for aromatic tertiary amines; $Ar^8$ through $Ar^{13}$ are aromatic groups having 6 to 20 carbon atoms and may be the same or different; and each a is, individually, zero or 1. The aromatic groups may be substituted, if desired, with groups or radicals such as hydroxyl, alkoxy, acyl or alkyl.

(3) Aromatic polycyclic compounds having at least three fused benzene rings and having an ionization energy less than about 7.5 ev., as calculated by the method of F. A. Matsen, *J. Chem. Physics*, 24, 602 (1956).

Other useful classes of sensitizers are xanthenes, thiazoles, polymethines, methines, acridines, diphenylmethanes, thiazines, azines, aminoketones, porphyrins, aromatic polycyclic hydrocarbons, p-substituted aminostyryls, aminotriaryl methanes, non-basic propenone compounds described in U.S. Patent 3,617,288.

Representative examples of sensitizers coming within the above useful classes include:

triphenylamine
dinaphthylphenylamine
N,N-diphenyl-N-p-methoxyphenylamine
9-(N,N-diphenylamino)-anthracene
N,N,N',N'-tetraphenyl-p-phenylenediamine
N,N,N',N'-tetraphenylbenzidine
N-phenylphenothiazine
N-phenylphenoxazine N,N'-diphenyldibenzopiperazine
N-phenyl-9,10-dihydroacridine
N-naphthylacridine
4,4'-diphenylaminodiphenylether
anthracene
2-ethyl-9,10-dimethoxyanthracene
9,10-diethoxyanthracene
1,2-benzanthracene
perylene
rubrene
tetraphenylpyrene
9,10-diphenylanthracene
tetracene
pentacene
anthanthrene
Rhodamine 6G (C.I. 45160)
Acridine Orange (C.I. 52015)
Hematoporphyrin
Protoporphyrin
Benzoflavin

The above classes of sensitizers, together with additional examples of each, may be found in U.S. Patent Numbers 3,515,552; 3,617,288; 3,640,718; 3,729,313 and 4,069,054.

Colorants, fillers, viscosity modifiers, extenders, and so forth may also be incorporated into the photopolymerizable layer. Typically these ingredients comprise up to about 75 parts by weight per 100 parts by weight of the cationically polymerizable material.

Useful colorants include pigments such as carbon black (e.g., "Raven 22" available from Cities Service) and dyes. They may be opaque and may be conductive or resistive materials. Such materials may include fine metal powders.

Useful fillers and viscosity modifiers include talc, clay, aluminum oxide, silica (e.g., "Cab-O-Sil U—5" from Cabot Corporation), etc.

Useful extenders include organic resins such as segmented polyester resins prepared as described in U.S. Patent 4,049,483, and hydroxy terminated polyester resins such as "Multron R—18" available from Mobay Chemical Company. Still other useful polyesters include the aliphatic polyesters of sebacic acid and 1,4-cyclohexane dimethanol.

The formation and transfer of images according to the present invention is achieved in a surprisingly simple manner. Thus, referring to the drawings, Figure 1 illustrates an imageable, composite dry-transfer sheet 1 comprising a cover sheet 2 that has an oleophilic surface, a base sheet 4 that has an oleophobic surface, and a photopolymerizable layer 6 interposed between the oleophilic surface of cover sheet 2 and the oleophobic surface of base sheet 4.

In use, as illustrated in Figures 2—6, images are formed in sheet 1 by placing an original 10 in contact with cover sheet 2. Preferably original 10 is in intimate contact with cover sheet 2. Original 10 has areas 11 which are non-transmissive to activating radiation 14 and areas 12 that are transmissive to activating radiation 14.

Sheet 1 is exposed to activating radiation 14 (See Figure 2) through original 10 for a time and at an intensity sufficient to cause the formation of polymerized areas 6a in photopolymerizable layer 6. Areas 6a correspond directly to the transmissive areas 12 of original 10.

Areas 6b in photopolymerizable layer 6 are not exposed to radiation 14 and therefore do not polymerize. Areas 6b correspond directly to non-transmissive areas 11 of original 10.

The photopolymerizable layer is generally exposed to ultraviolet light for a short period of time, e.g., three minutes, to bring about image-wise polymerization of the exposed areas of layer 6. The resultant areas 6a and 6b represent a negative and a positive, respectively, of the image on original 10.

After exposure to radiation 14, cover sheet 2 is peeled apart from sheet 1 (see Figure 3) to provide component A bearing unpolymerized areas 6b and component B bearing polymerized areas 6a.

Component A is then exposed to activating radiation 15 through cover sheet 2 for a time and at an intensity to at least partially polymerize areas 6b. See Figure 4. After exposure, component A is placed in contact with a receptor 16 such that the now at least partially exposed areas 6b contact the receptor. See Figure 5.

Pressure is then applied to the backside 3 of component A, for example by a burnishing tool 18, over the areas 6b to be transferred. After burnishing, component A is peeled off of receptor 16. See Figure 6. In so doing, areas 6b release from cover sheet 2 of component A and adhere to receptor 16. The transferred image areas are non-tacky and resistant to smearing and abrasion.

Typically the exposure of component A is to ultraviolet light and requires only about 30 seconds to achieve transferability for partially polymerized areas 6b. Slightly longer times (e.g., 3 minutes or more) are normally required to effect complete polymerization of areas 6b.

Component B cannot be burnished but can serve as an original to make a negative image that is burnishable. Thus, the negative image produced with another sheet of the invention thereon may be transferred to a receptor in a similar manner as employed to transfer a positive image. Component B may also be used as a sign or label.

Although the activating radiation has been described only with reference to ultraviolet light, the photopolymerizable layer will also polymerize upon exposure to a source of radiation of other wavelengths, e.g., visible light. Suitable sources of radiation include mercury, xenon, carbon arc, tungsten filament lamps, sunlight, etc. Exposures may be from less than 30 seconds to more than 15 minutes depending upon the amounts of particular polymerizable materials and complex salts being utilized, the absence or presence of sensitizers, the radiation source and distance from the source, the transmissivity of the photopolymerizable layer to the activating radiation, and the thickness of the photopolymerizable layer to be polymerized. The compositions may also be polymerized by exposure to electron beam irradiation. Generally speaking the dosage necessary is from less than 1 megarad to 100 megarad or more.

The imageable sheets of the invention may be readily prepared using conventional processing techniques. Thus the photopolymerizable composition is first prepared by combining the cationically polymerizable material and any colorants to be employed. The remaining components of the photopolymerizable layer are mixed together and then combined with the cationically polymerizable material and the colorant. Conventional mixing techniques are utilized. The combination of ingredients is mixed until uniform and then applied to the non-polar surface of the oleophilic cover sheet by, for example, knife, reverse roll, or Meyer bar coating.

The coated cover sheet is then typically dried at less than 70°C for one half to five minutes. The resulting photopolymerizable layer is typically 2.5 to 25 micrometers thick. The base sheet is then laminated to the photopolymerizable layer by, for example, conventional techniques so that an oleophobic

surface contacts the photopolymerizable layer. The preparation of the imageable sheet is carried out in the absence of activating radiation.

The present invention is further illustrated with reference to the following examples wherein the term parts refers to parts by weight unless otherwise noted.

Example 1

Imageable composite dry-transfer sheets according to the invention were prepared. The cover sheet comprised a section of biaxially oriented poly(ethylene terephthalate) (PET) film which had an oleophilic coating of a silicone surface-active agent on one surface. This film was obtained from Akrosil Corporation as type 2C—5459. It was 35 micrometers thick.

The cationically polymerizable photopolymerizable layer was applied from a composition that contained the following ingredients:

| Ingredient | Parts |
|---|---|
| 3,4-epoxycyclohexylmethyl-3,4-epoxycyclohexane carboxylate ("Bakelite ERL—4221" from Union Carbide Corporation) | 15.4 |
| Carbon black ("Raven 22", a furnace carbon black from the Columbian Division of Cities Service Company) | 4.3 |
| Triarylsulfonium hexafluoroantimonate (10% by weight solution in methyl ethyl ketone (TASHFA)* | 7.7 |
| 2-ethyl-9,10-dimethoxyanthracene (5% by weight solution in methyl ethyl ketone) (EDMA) | 7.7 |
| Pyrogenic silica ("Cab-O-Sil M—5" from Cabot Corporation) | 1.2 |
| Segmented polyester resin (25% by weight in methyl ethyl ketone) prepared according to Example 1 of U.S. Patent 4,049,483, col. 6, lines 53—68 | 19.7 |
| Thermoplastic rubber (25% by weight in toluene. A block copolymer available as "Kraton 1101" from Shell Chemical Company) | 9.9 |
| Methyl ethyl ketone (MEK) | 34.1 |

* 50% by weight 4-phenylthiophenyldiphenylsulfonium hexafluoroantimonate
45% by weight triphenylsulfonium hexafluoroantimonate
5% by weight 4-chlorophenyldiphenylsulfonium hexafluoroantimonate

The composition was coated onto the oleophilic surface of the PET with a No. 22 Mayer bar and then dried at 65°C for 2 minutes in an air circulating oven. An oleophobic base sheet of PET film was then laminated to the dried photopolymerizable layer.

The resultant imageable, composite dry-transfer sheet was image-wise exposed to ultraviolet (UV) light in a model "EU 8000 Ultraviolet Exposure" unit from 3M. Exposure was achieved by placing a stencil on the cover sheet and exposing the transfer sheet through the stencil to ultraviolet light from General Electric fluorescent lamps (model number F15T8—BL) for three minutes. Intimate contact was maintained between the stencil and the transfer sheet by placing a glass plate over the stencil and pressing the stencil/sheet combination onto a sponge with the oleophobic base sheet of the transfer sheet in contact with the sponge.

After exposure, the cover sheet was stripped away from the base sheet. The cover sheet had an unpolymerized positive image on it while the base sheet had a polymerized negative image on it. The positive and negative images separated cleanly from each other.

The cover sheet (with positive image) was placed in the exposure unit with the imaged side in contact with a sheet of plain bond paper which had been folded in an accordion-like fashion so that the image areas had minimal contact therewith. The image areas were then exposed through the cover sheet to ultraviolet light for 30 seconds. The cover sheet (with the partially cured positive image) was then placed upon a receptor (a sheet of bond paper) so that the partially cured images were in contact with the receptor. The images were then transferred to the paper receptor by applying pressure to the back of the cover sheet with a burnishing tool. When the cover sheet was separated from the bond paper, the burnished image was completely transferred to and adhered on the paper. The surface of the image was non-tacky and resistant to smearing and abrasion.

Sheets prepared according to this example were also found useful in transferring images to other receptors such as cardboard, acetate film, poly(ethylene terephthalate) film and metal foil.

Example 2

Example 1 was repeated except that the photopolymerizable layer was applied to the cover sheet from the following composition:

| Ingredient | Parts |
|---|---|
| "ERL—4221" (Union Carbide Corporation) | 17.2 |
| "Raven—22" (Cities Service Company) | 4.8 |
| TASHFA (10% by weight in MEK) | 8.5 |
| EDMA (5% by weight in MEK) | 8.5 |
| "Cab-O-Sil M—5" (Cabot Corporation) | 1.3 |
| Acrylic resin ("Elvacite 2041" from E. I. DuPont 25% by weight in MEK) | 10.9 |
| Hydroxy terminated polyester ("Multron R—18" from Mobay Chemical Company) | 10.9 |
| MEK | 37.9 |

The dry transfer sheet was imaged as described in Example 1 and the base sheet and the cover sheet stripped away from each other. Separate portions of the cover sheet, bearing an unpolymerized positive image, were post exposed for various lengths of time as described in Example 1 to partially cure the image. The positive images were then transferred to a piece of bond paper by burnishing as described in Example 1. The results of the tests are set forth in Table 1.

TABLE 1

| Post Exposure (Min) | Comments |
|---|---|
| 3 | Complete transfer. Images non-tacky and resistant to abrasion and smearing. |
| 6 | Complete transfer. Images non-tacky and resistant to abrasion and smearing. |
| 9 | Complete transfer. Images non-tacky and resistant to abrasion and smearing. |
| 12 | Some loss in burnishability in that additional pressure needed to burnish. Images less resistant to abrasion. |
| 15 | Some loss in burnishability in that more pressure needed than required in 12 min. exposure sample. Images less resistant to abrasion. |

Examples 3—11

A series of imageable composite dry-transfer sheets according to the invention were prepared according to the procedures described in Example 1 except that the photopolymerizable layer of each was different. In each example the cover sheet comprised a section of biaxially oriented PET that had been

coated with a silicone surface-active agent to render one surface oleophilic. The silicone-treated cover sheet was "UBL 110—1" available from Akrosil Corporation. The oleophobic base sheet in each example was a biaxially oriented PET film.

Each sheet was imaged and used in a burnishing process as described in Example 1 except that the positive image, which was transferred by burnishing, was burnishable even though it was completely polymerized by the post exposure. Post exposures of up to 15 minutes were used. In all cases the transferred images were non-tacky and resistant to abrasion and smearing.

The components used in the photopolymerizable compositions are set forth below in Table 2.

TABLE 2

| COMPOSITION | EXAMPLE 3 | 4 | 5 | 6 | 7 | 8 | 9 | 10 | 11 |
|---|---|---|---|---|---|---|---|---|---|
| "ERL–4221" | 22.8 | 19.3 | | | | | | | |
| "ERL–4299" (1) | | | 24 | 24 | 24 | 24 | 25.7 | | |
| Divinylether of diethylene glycol (2) | | | | | | | | 24 | 24 |
| "Raven 22" | 6.4 | 5.4 | 6.8 | 6.8 | 6.8 | 6.8 | | 6.8 | 6.8 |
| TASHFA | 1.5 | 1.2 | 1.5 | | | | 1.7 | 1.5 | |
| Diphenyliodonium hexafluorophosphate | | | | 1.5 | | | | | |
| Bis-(2,4-dimethylphenyl) iodonium hexafluoroantimonate | | | | | 1.5 | | | | |
| Triarylsulfonium hexafluoroarsenate (3) | | | | | | 1.5 | | | |
| 1-methyl-3,5-bistrichloromethyl triazine | | | | | | | | | 1.5 |

(1) bis(3,4-epoxy-6-methylcyclohexylmethyl) adipate available from Union Carbide Corporation.

(2) Available from GAF.

(3) 50% by weight 4-phenylthiophenyldiphenylsulfonium hexafluoroarsenate.

45% by weight triphenylsulfonium hexafluoroarsenate.

5% by weight 4-chlorophenyldiphenylsulfonium hexafluoroarsenate.

TABLE 2 (Continued)

| COMPOSITION | EXAMPLES | | | | | | | | |
|---|---|---|---|---|---|---|---|---|---|
| | 3 | 4 | 5 | 6 | 7 | 8 | 9 | 10 | 11 |
| EDMA | 1.5 | 1.2 | 1.5 | 1.5 | 1.5 | 1.5 | 1.7 | 1.5 | 1.5 |
| Aliphatic polyester of sebacic acid and 1,4-cyclohexane dimethanol (50% by weight in toluene) | 18.3 | | | | | | | | |
| "Foral 85" (75% by weight in MEK) (4) | 10 | 16.1 | 15.4 | 15.4 | 15.4 | 15.4 | 16.5 | 15.4 | 15.4 |
| "Elvacite 2044" (25% by weight in MEK) (5) | 14.6 | 12.4 | 15.4 | 15.4 | 15.4 | 15.4 | 16.5 | 15.4 | 15.4 |
| "Kraton 1101" (25% by weight in MEK) | 22 | | | | | | | | |
| "Kraton 1650" (20% by weight in 50/50 toluene/heptane) (6) | | 18.6 | 23.1 | 23.1 | 23.1 | 23.1 | 24.7 | 23.1 | 23.1 |

(4) A hydrogenated ester resin from Hercules, Inc.

(5) An n-butyl methacrylate polymer from DuPont.

(6) A thermoplastic rubber/styrene block copolymer, available from Shell Chemical Co.

TABLE 2 (Continued)

| COMPOSITION | EXAMPLES 3 | 4 | 5 | 6 | 7 | 8 | 9 | 10 | 11 |
|---|---|---|---|---|---|---|---|---|---|
| "Drakeol 35"[(7)] | | 1 | | | | | | | |
| "Shell max 500" (25% by weight in toluene) [(8)] | | 12.4 | 12.3 | 12.3 | 12.3 | 12.3 | 13.2 | 12.3 | 12.3 |
| "Elvax 150" (25% by weight in MEK) [(9)] | | 12.4 | | | | | | | |
| Ethanol | 2.9 | | | | | | | | |

[(6)] (7) A white mineral oil available from Pennsylvania Refining Co.

[(7)] (8) A microcrystalline wax available from Shell Chemical Co.

[(9)] (9) An ethylene/vinyl acetate copolymer available from E. I. du Pont de Nemours.

Example 12

Imageable composite dry-transfer sheets according to the invention were prepared. The cover sheet comprised a section of biaxially oriented PET film which had been coated with a silicone surface-active agent to render its surface oleophilic. The film was "UBL 110—1" available from Akrosil Corporation. A sheet of PET film was employed as the oleophobic base sheet.

The cationically polymerizable layer was applied from a composition that contained the following ingredients:

| Ingredient | Parts |
|---|---|
| "ERL 4299" | 19.5 |
| "Raven 22" | 5.5 |
| "Elvacite 2044" (25% in MEK) | 12.4 |
| TASHFA | 1.2 |
| 9,10-Diethoxyanthracene (DEA) | 1.2 |
| "Kraton 1650" | 3.7 |
| "Shellmax 500" | 2.5 |
| "Piccolastic A—25" (polystyrene resin from Hercules Chemical Co.) | 6.8 |
| Toluene/Heptane (1:1) | 19.6 |
| MEK | 27.6 |

The "Kraton 1650", "Shellmax 500" and "Piccolastic A—25" were mixed together under high shear using a laboratory Dispersator with a Hi-Vis® head (Hi-Vis is a Registered Trade Mark in some countries). Mixing was carried out at a temperature of about 150°C for 30 min. The mixture was then cooled below room temperature with dry ice, ground into small chunks and solubilized with a 1:1 by weight blend of toluene:heptane to a final solids content of 40%. The remaining ingredients were then added to the solution and the entire formulation was run through a Manton Gaulin laboratory homogenizer at 55160 kPa (8,000 PSI). The resulting formulation was coated onto the oleophilic surface of the cover sheet to a thickness of 0.00125 cm. It was then oven dried for two minutes at about 65°C and the base sheet was then laminated thereover. The resulting sheet was then image-wise exposed, the base and cover sheets separated and the unexposed areas post exposed and used in a burnishing process as described in examples 3—11. The positive images were burnishable even though they had been completely polymerized by the post exposure. The transferred images were non-tacky and resistant to abrasion and smearing.

Example 13

Example 1 was repeated except that the photopolymerizable layer was applied to the oleophilic surface of the cover sheet from the following composition:

| Ingredient | Parts |
|---|---|
| "ERL 4221" | 78 |
| "Raven 22" | 22 |
| TASHFA (10% by weight in MEK) | 39 |
| EDMA (10% by weight in MEK) | 39 |
| "Cab-O-Sil M—5" | 6 |
| Solid polystyrene resin ("Dow—685" from Dow Chem. 12½% by weight in MEK) | 50 |
| MEK | 173 |

The dry transfer sheet was imaged as described in Example 1 and the base sheet and the cover sheet stripped away from each other. The cover sheet (with positive image) was then exposed to ultraviolet light for a brief time as described in Example 1 and the images were then burnished onto bond paper. The surface of the image was non-tacky and resistant to smearing and abrasion.

Example 14

Example 1 was repeated except that the photopolymerizable layer was applied to the oleophilic surface of the cover sheet from the following composition:

| Ingredient | Parts |
|---|---|
| "ERL 4221" | 78 |
| "Raven 22" | 22 |
| TASHFA (10% by weight in MEK) | 39 |
| EDMA (10% by weight in MEK) | 39 |
| "Cab-O-Sil M—5" | 6 |
| "Dow—685" (12.5% by weight in MEK) | 20 |
| MEK | 173 |

The dry transfer sheet was imaged as described in Example 1 and the base sheet and the cover sheet stripped away from each other. The cover sheet (with positive image) was then exposed to ultraviolet light for a brief time as described in Example 1 and the images were then burnished onto bond paper. The surface of the image was non-tacky and resistant to smearing and abrasion.

Example 15

Example 1 was repeated except that the photopolymerizable layer was applied to the oleophilic surface of the sheet from the following composition:

| Ingredient | Parts |
|---|---|
| "ERL 4221" | 78 |
| "Raven 22" | 22 |
| TASHFA (10% by weight in MEK) | 39 |
| EDMA (10% by weight in MEK) | 39 |
| "Cab-O-Sil M—5" | 6 |
| Acrylic resin ("Elvacite 2044" from E. I. DuPont de Nemours and Company, 25% by weight in MEK) | 20 |
| MEK | 173 |

The dry transfer sheet was imaged as described in Example 1 and the base sheet and the cover sheet stripped away from each other. The cover sheet (with positive image) was then exposed to ultraviolet light for a brief time as described in Example 1 and the images were then burnished onto bond paper. The surface of the image was non-tacky and resistant to smearing and abrasion.

Example 16

Example 1 was repeated except that the photopolymerizable layer was applied to the oleophilic cover sheet from the following composition:

| Ingredient | Parts |
|---|---|
| "ERL 4221" | 78 |
| "Raven 22" | 22 |
| TASHFA (10% by weight in MEK) | 39 |
| EDMA (10% by weight in MEK) | 39 |
| "Cab-O-Sil M—5" | 6 |
| "Kraton 1101" (25% by weight in MEK) | 50 |
| MEK | 173 |

The dry transfer sheet was imaged as described in Example 1 and the base sheet and the cover sheet stripped away from each other. The cover sheet (with positive image) was then exposed to ultraviolet light for a brief time as described in Example 1 and the images were then burnished onto bond paper. The surface of the image was non-tacky and resistant to smearing and abrasion.

Examples 17—18

Imageable composite dry-transfer sheets were prepared as described in Example 1 using the following compositions as the photopolymerizable layer.

| Ingredients | Parts 17 | Parts 18 |
|---|---|---|
| "Epon 836" (softening point of 40—45°C available from Shell Chemical Company) | 45.4 | — |
| "Epon 1001" (softening point of 65—75°C available from Shell Chemical Company) | — | 45.6 |
| TASHFA | 2.3 | 2.3 |
| DEA | 2.3 | 2.3 |
| MEK | 50 | 50 |
| Modulus of Photopolymerizable Layer (Pa (dynes/cm$^2$)) | 4.04 ($8 \times 10^5$) | 5050 ($1 \times 10^{10}$) |

The dry transfer sheets were imaged as described in Example 1 and the base and cover sheets stripped away from each other. In Example 17, the positive image released from the base sheet and adhered to the cover sheet while the negative image did the opposite, thereby exhibiting the desired adhesion/cohesion relationships among the base sheet, the cover sheet and the photopolymerizable layer. In Example 18, neither the positive nor the negative image released from the base sheet but rather both adhered to the cover sheet.

**Claims**

1. An imageable composite dry-transfer sheet that comprises (a) a cover sheet that is transmissive to activating radiation, (b) a photopolymerizable layer on the surface of said cover sheet that comprises a polymerizable organic material, and a photopolymerization initiator, and (c) a base sheet wherein, after image-wise exposure to activating radiation, the interfacial adhesion of the unexposed areas of said photopolymerizable layer is greater for said cover sheet than for said base sheet and the interfacial adhesion of the exposed areas of said photopolymerizable layer is greater for said base sheet than for said cover sheet characterised in that said cover sheet has at least one oleophilic surface, the photopolymerizable layer comprises a cationically polymerizable organic material and from 0.1 to 10 parts by weight per 100 parts by

weight of the organic material of a cationic photopolymerization initiator, and the layer has a complex shear modulus of, at most, 5.05 Pa ($1 \times 10^6$ dyme/$cm^2$) and, after separation of said cover and said base sheets, the unexposed areas of said layer are rendered burnishable by subsequent exposure to activating radiation through said cover sheet.

2. An imageable sheet according to claim 1 wherein said photopolymerizable layer further comprises from 1 to 100 parts by weight per 100 parts by weight of said organic material of a thermoplastic hydrocarbon resin that has a ring and ball softening point of more than 100°C said thermoplastic hydrocarbon resin being chemically inert to said organic resin and said initiator.

3. An imageable sheet according to claim 1 wherein said cationically polymerizable organic material is selected from epoxides that have an epoxide functionality of at least one, and materials that have at least one vinyl ether group.

4. An imageable sheet according to claim 3 wherein said cationically polymerizable organic material is an epoxide having an epoxide functionality of at least one.

5. An imageable sheet according to claim 3 wherein said organic material contains at least one vinyl ether group.

6. An imageable sheet according to any one of claims 1 to 5 wherein said initiator is an aromatic onium salt that has a formula selected from

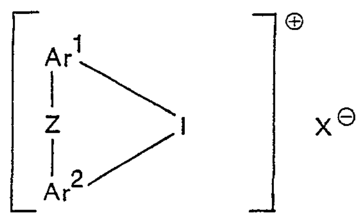

(A)

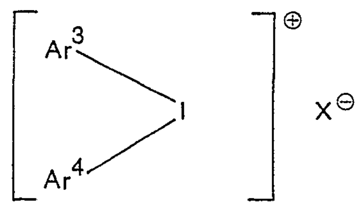

(B)

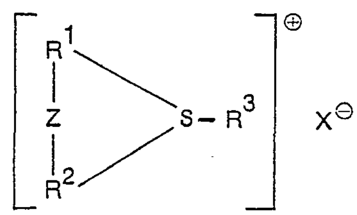

(C)

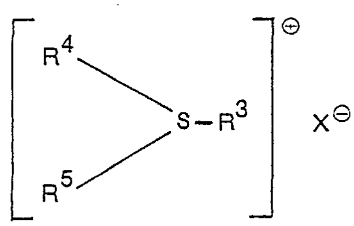

(D)

wherein

$Ar^1$ and $Ar^2$ are the same or different substituted or unsubstituted divalent aromatic groups that contain from 6 to 20 carbon atoms;

$Ar^3$ and $Ar^4$ are the same or different substituted or unsubstituted monovalent aromatic groups that contain from 7 to 20 carbon atoms;

$R^1$ and $R^2$ are selected from substituted and unsubstituted divalent aromatic groups that contain from 6 to 20 carbon atoms and substituted and unsubstituted alkylene groups that contain from 1 to 20 carbon atons;

$R^3$, $R^4$, and $R^5$ are each selected from substituted and unsubstituted monovalent aromatic groups that contain from 6 to 20 carbon atoms and substituted and unsubstituted alkyl groups that contain from 1 to 20 carbon atoms; provided that at least one of $R^1$, $R^2$, and $R^3$ is aromatic in formula C and at least one of $R^3$, $R^4$, and $R^5$ is aromatic in formula D;

Z is selected from the group consisting of a carbon-to-carbon bond, oxygen, sulfur,

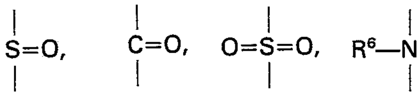 wherein $R^6$ is aryl or acyl, 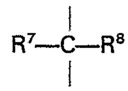

wherein $R^7$ and $R^8$ are selected from hydrogen, alkyl groups that contain from about 1 to 4 carbon atoms, and alkenyl groups that contain from about 2 to 4 carbon atoms; and

X is a halogen-containing complex anion.

7. An imageable sheet according to any one of claims 1 to 5 wherein said initiator is selected from

a) halogen-containing organic compounds which contain halogen attached to carbon and which, upon exposure to radiation of suitable wavelength, is dissociable with formation of halogen-free radicals, the bond dissociation energy for the carbon-to-halogen bond being in the range of 167 to 293 kilojoules per mole (40 to 70 kilocalories per mole); and

b) an aromatic onium salt that has a formula selected from

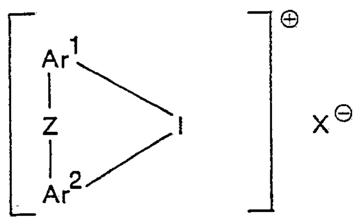 (A)

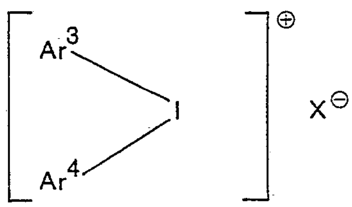 (B)

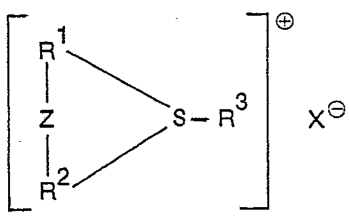 (C)

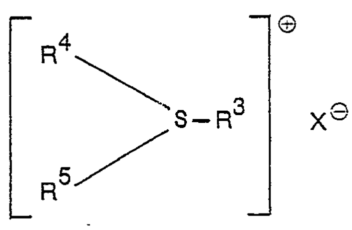 (D)

wherein $Ar^1$ and $Ar^2$ are the same or different substituted or unsubstituted divalent aromatic groups that contain from about 6 to 20 carbon atoms;

$Ar^3$ and $Ar^4$ are the same or different substituted or unsubstituted monovalent aromatic groups that contain from about 6 to 20 carbon atoms;

$R^1$ and $R^2$ are selected from substituted and unsubstituted divalent aromatic groups that contain from about 6 to 20 carbon atoms and substituted or unsubstituted alkylene groups that contain from 1 to about 20 carbon atoms;

$R^3$, $R^4$, and $R^5$ are each selected from substituted and unsubstituted monovalent aromatic groups that contain from about 6 to 20 carbon atoms and substituted and unsubstituted alkyl groups that contain from 1 to about 20 carbon atoms; provided that at least one of $R^1$, $R^2$, and $R^3$ is aromatic in formula C and at least one of $R^3$, $R^4$, and $R^5$ is aromatic in formula D;

Z is selected from a carbon-to-carbon bond, oxygen, sulfur,

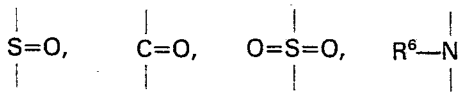 wherein $R^6$ is aryl or acyl, 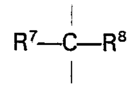

wherein $R^7$ and $R^8$ are selected from hydrogen, alkyl groups that contain from about 1 to 5 carbon atoms, and alkenyl groups that contain from about 2 to 4 carbon atoms, and

X is a halogen-containing complex anion.

8. An imageable sheet according to claim 7 wherein said initiator is selected from triarylsulfonium hexafluoroantimonate and triarylsulfonium hexafluoroarsenate.

9. An imageable sheet according to claim 1 wherein said photopolymerizable layer further includes at least one material selected from plasticizing agents, tackifiers, extenders, colorants, fillers, and viscosity modifiers.

10. A process for image production and transfer including the steps of

providing a dry-transfer sheet having a cover sheet transmissive to activating radiation, a photopolymerizable layer on the cover sheet, and a base sheet in contact with the photopolymerizable layer and exposing the dry-transfer sheet to activating radiation through the cover sheet to provide photopolymerized areas in the dry-transfer sheet;

separating the base sheet and cover sheet of the exposed dry-transfer sheet, wherein the photopolymerized areas of the photopolymerizable layer adhere to the base sheet and the non-photopolymerized areas of the photopolymerizable layer adhere to the cover sheet;

characterized by the feature that (a) the cover sheet has at least one oleophilic surface which contacts the photopolymerizable layer, (b) the photopolymerizable layer comprises a cationically polymerizable organic material, and from about 0.1 to 10 parts by weight per 100 parts by weight of the organic material of a cationic photopolymerizable initiator, and (c) the base sheet has an oleophobic surface which contacts the photopolymerizable layer;

further characterized by the steps of irradiating the non-photopolymerized areas through the cover sheet with activating radiation for a time sufficient to at least partially photopolymerize the non-photopolymerized areas; and

transferring the at least partially photopolymerized areas from the base sheet to a receptor by burnishing.

**Patentansprüche**

1. Bildaufnahmefähiges Trockenübertragungs-Verbundblatt, das (a) ein für aktivierende Strahlung durchlässiges Deckblatt, (b) eine auf der Oberfläche des Deckblattes vorgesehene, photopolymerisierbare Schicht besitzt, die ein polymerisierbares organisches Material und einen photopolymerisationsinitiator enthält, und (c) ein Tragblatt besitzt, wobei nach der bildmäßigen Einwirkung von aktivierender Strahlung die Grenzflächenhaftung der unbestrahlten Flächenbereiche der photopolymerisierbaren Schicht an dem Deckblatt stärker ist als an dem Tragblatt und die Grenzflächenhaftung der bestrahlten Flächenbereiche der photopolymerisierbaren Schicht an der Tragschicht stärker ist als an dem Deckblatt, dadurch gekennzeichnet, daß das Deckblatt mindestens eine oleophile Oberfläche besitzt, die photopolymerisierbare Schicht ein kationisch polymerisierbares organisches Material und einen kationischen photopolymerisationsinitiator in einer Menge von 0,1 bis 10 Gewichtsteilen pro 100 Gewichtsteile des organischen Materials enthält, und die Schicht einen komplexen Schermodul von höchstens 5,05 Pa besitzt, und daß nach der Trennung des Deckblattes und des Tragblattes voneinander die unbestrahlten Flächenbereiche der genannten Schicht durch das Deckblatt hindurch einer aktivierenden Strahlung ausgesetzt und dadurch durch Aufquetschen übertragbar gemacht werden.

2. Bildaufnahmefähiges Blatt nach Anspruch 1, dadurch gekennzeichnet, daß die photopolymerisierbare Schicht in einer Menge von 1 bis 100 Gewichtsteilen pro 100 Gewichtsteile des genannten organischen Materials ein thermoplastisches Kohlenwasserstoffharz enthält, das einen Ring- und Kugel-Erweichungspunkt über 100°C besitzt und gegenüber dem genannten organischen Harz und dem genannten Initiator chemisch inert ist.

3. Bildaufnahmefähiges Blatt nach Anspruch 1, dadurch gekennzeichnet, daß das kationisch polymerisierbare organische Material ausgewählt ist aus Epoxiden mit mindestens einer Epoxidfunktionalität und Materialien mit mindestens einer Vinylethergruppe.

4. Bildaufnahmefähiges Blatt nach Anspruch 3, dadurch gekennzeichnet, daß das kationisch polymerisierbare organische Material ein Epoxid mit mindestens einer Epoxidfunktionalität ist.

5. Bildaufnahmefähiges Blatt nach Anspruch 3, dadurch gekennzeichnet, daß das organische Material mindestens eine Vinylethergruppe enthält.

6. Bildaufnahmefähiges Blatt nach einem der Ansprüche 1 bis 5, dadurch gekennzeichnet, daß der genannte Initiator ein aromatisches Oniumsalz mit einer der nachstehenden Formeln ist:

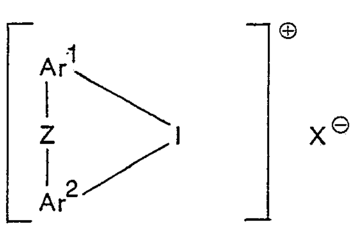

(A)

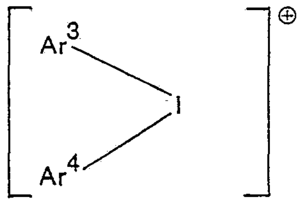

(B)

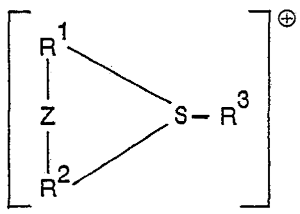

(C)

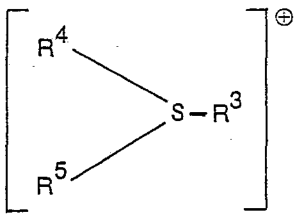

(D)

wobei

$Ar^1$ und $Ar^2$ gleiche oder verschiedene, substituierte oder nichtsubstituierte, zweiwertige aromatische Gruppen mit 6 bis 20 Kohlenstoffatomen sind,

$Ar^3$ und $Ar^4$ gleiche oder verschiedene, substituierte oder nichtsubstituierte einwertige aromatische Gruppen mit 7 bis 20 Kohlenstoffatomen sind,

$R^1$ und $R^2$ ausgewählt sind aus den substituierten und nichtsubstituierten zweiwertigen aromatischen Gruppen mit 6 bis 20 Kohelnstoffatomen und den substituierten und nichtsubstituierten Alkylengruppen mit 1 bis 20 Kohlenstoffatomen,

$R^3$, $R^4$ und $R^5$ jeweils ausgewähltt sind aus den substituierten und nichtsubstituierten einwertigen aromatischen Gruppen mit 6 bis 20 Kohlenstoffatomen und den substituierten und nichtsubstituierten Alkylgruppen mit 1 bis 20 Kohlenstoffatomen,

in der Formel C mindestens eine der Gruppen $R^1$, $R^2$ und $R^3$ aromatisch und in der Formel D mindestens eine der Gruppen $R^3$, $R^4$ und $R^5$ aromatisch ist,

Z ausgewählt ist aus einer Kohlenstoff-Kohlenstoff-Bindung, Sauerstoff, Schwefel

S=O, C=O, O=S=O, $R^6$—N wobei $R^6$ Aryl oder Acyl ist, $R^7$—C—$R^8$,

wobei $R^7$ und $R^8$ ausgewählt sind aus Wasserstoff, Alkylgruppen mit etwa 1 bis 4 Kohlenstoffatomen und Alkenylgruppen mit etwa 2 bis 4 Kohlenstoffatomen, und

X ein halogenhaltiges komplexes Anion ist.

7. Bildaufnahmefähiges Blatt nach einem der Ansprüche 1 bis 5, dadurch gekennzeichnet, daß der genannten Initiator ausgewählt ist aus

a) halogenhaltigen Verbindungen, die an Kohlenstoff gebundenes Halogen enthalten und unter der Einwirkung einer Strahlung von geeigneter Wellenlänge unter Bildung von halogenfreien Radikalen dissoziierbar sind, wobei die Bindungsdissoziationsenergie für die Kohlenstoff-Kohlenstoffbindung im Bereich von 167 bis 193 Kilojoule pro Mol (40 bis 70 Kilokalorien pro Mol) liegt.

b) einem aromatischen Oniumsalz der Formel

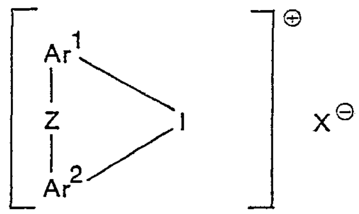

(A)

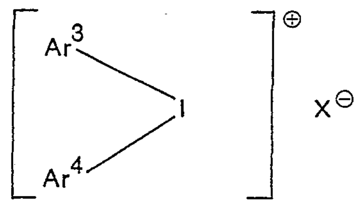

(B)

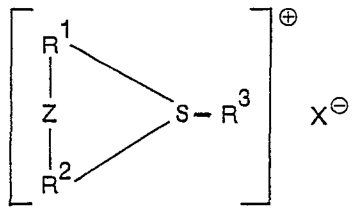

(C)

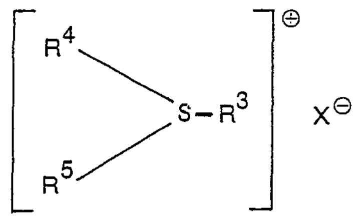

(D)

wobei

$Ar^1$ und $Ar^2$ gleiche oder verschiedene, substituierte oder nichtsubstituierte, zweiwertige aromatische Gruppen mit etwa 6 bis 20 Kohlenstoffatomen sind,

$Ar^3$ und $Ar^4$ gleiche oder verschiedene, substituierte oder nichtsubstituierte einwertige aromatische Gruppen mit 7 bis 20 Kohlenstoffatomen sind,

$R^1$ und $R^2$ ausgewählt sind aus den substituierten und nichtsubstituierten zweiwertigen aromatischen Gruppen mit 6 bis 20 Kohlenstoffatomen und den substituierten und nichtsubstituierten Alkylengruppen mit 1 bis 20 Kohlenstoffatomen,

$R^3$, $R^4$ und $R^5$ jeweils ausgewählt sind aus den substituierten und nichtsubstituierten einwertigen aromatischen Gruppen mit 6 bis 20 Kohlenstoffatomen und den substituierten und nichtsubstituierten Alkylgruppen mit 1 bis 20 Kohlenstoffatomen,

in der Formel C mindestens eine der Gruppen $R^1$, $R^2$ und $R^3$ aromatisch und in der Formel D mindestens eine der Gruppen $R^3$, $R^4$ und $R^5$ aromatisch ist,

Z ausgewählt ist aus einer Kohlenstoff-Kohlenstoff-Bindung, Sauerstoff, Schwefel

S=O, C=O, O=S=O, $R^6$—N wobei $R^6$ Aryl oder Acyl ist, $R^7$—C—$R^8$

wobei $R^7$ und $R^8$ ausgewählt sind aus Wasserstoff, Alkylgruppen mit etwa 1 bis 4 Kohlenstoffatomen und Alkenylgruppen mit etwa 2 bis 4 Kohlenstoffatomen, und

X ein halogenhaltiges komplexes Anion ist.

8. Bildaufnahmefähiges Blatt nach Anspruch 7, dadurch gekennzeichnet, daß der genannte Initiator aus Triarylsulfoniumhexfluorantiomonat und Triarylsulfoniumhexfluorarsenat ausgewählt ist.

9. Bildaufnahmefähiges Blatt nach Anspruch 1, dadurch gekennzeichnet, daß die photopolymerisierbare Schicht ferner mindestens ein Material enthält, das ausgewählt ist aus den Weichmachern, Klebrigmachern, Streckmitteln, Farbmitteln, Füllstoffen und Viskositätsmodifikatoren.

10. Verfahren zur Bilderzeugung und Übertragung, mit folgenden Schritten:

Es wird ein Trockenübertragungsblatt vorgesehen das ein für aktivierende Strahlung durchlässiges Deckblatt, eine auf dem Deckblatt vorgesehene, photopolymerisierbare Schicht und ein mit der photopolymerisierbaren Schicht in Berührung stehendes Tragblatt besitzt, und das Trockenübertragungsblatt wird durch das Deckblatt hindurch einer aktivierenden Strahlung ausgesetzt, so daß in dem Trockenübertragungsblatt photopolymerisierte Flächen gebildet werden, und

das Tragblatt und das Deckblatt des Trockenübertragungsblattes werden voneinander getrennt, wobei die photopolymerisierten Flächenbereiche der photopolymerisierbaren Shicht an dem Tragblatt und die nichtphotopolymerisierten Flächenbereiche der photopolymerisierbaren Schicht an dem Deckblatt haften;

dadurch gekennzeichnet, daß (a) das Deckblatt mindestens eine oleophile Fläche besitzt, die mit der photopolymerisierbaren Schicht in Berührung steht, (b) die photopolymerisierbare Schicht ein kationisch polymerisierbares organisches Material und pro 100 Gewichtsteile des organischen Materials etwa 0,1 bis 10 Gewichtsteile eines kationischen Photopolymerisationsinitiators enthält und (c) das Tragblatt eine oleophobe Fläche besitzt, die mit der photopolymerisierbaren Schicht in Berührung steht;

ferner dadurch gekennzeichnet, daß die nichtphotopolymerisierten Flächenbereiche durch das Deckblatt hindurch solange einer aktivierenden Strahlung ausgesetzt werden, daß die nichtphotopolymerisierten Flächenbereiche mindestens teilweise photopolymerisiert werden und

die mindestens teilweise photopolymerisierten Flächenbereiche durch Aufquetschen von dem Tragblatt auf einen Aufnahmekörper übertragen werden.

**Revendications**

1. Feuille composite de mise en image par transfert par voie sèche, qui comprend (a) une feuille de couverture qui laisse passer une radiation activante, (b) une couche photopolymérisable à la surface de ladite feuille de couverture qui comprend une matière organique polymérisable et un initiateur de photopolymérisation et (c) une feuille de support dans laquelle, après exposition à une radiation activante pour former l'image, l'adhérence interfaciale des aires non exposées de ladite couche photopolymerisable est plus grande pour ladite feuille de couverture que pour ladite feuille de support et l'adhérence interfaciale des aires exposées de la couche photopolymérisable est plus grande pour ladite feuille de support que pour ladite feuille de couverture, caractérisée en ce que la feuille de couverture a au moins une face oléophile, la couche photopolymérisable comprend une matière organique polymérisable par voie cationique et une proportion de 0,1 à 10 parties en poids, pour 100 parties en poids de la matière organique, d'un initiateur de photopolymérisation cationique et la couche a un module de cisaillement complexe d'une valeur maximale de 5,05 Pa ($1 \times 10^6$ dynes/$cm^2$) et, après séparation desdites feuilles de couverture et de support, les régions non exposées de ladite couche sont rendues aptes au transfert par pression par exposition ultérieure à une radiation activante à travers ladite feuille de couverture.

2. Feuille de mise en image suivant la revendication 1, dans laquelle ladite couche photopolymérisable comprend en outre 1 à 100 parties en poids, pour 100 parties en poids de ladite matière organique, d'une résine hydrocarbonée thermoplastique qui a un point de ramollissement bille-et-anneau de plus de 100°C, ladite résine hydrocarbonée thermoplastique étant chimiquement inerte vis-à-vis de ladite résine organique et dudit initiateur.

3. Feuille de mise en image suivant la revendication 1, dans laquelle ladite matière organique polymérisable par voie cationique est choisie entre des époxydes qui ont une fonctionnalité époxyde au moins égale à un, et des matières qui portent au moins un groupe éther de vinyle.

4. Feuille de mise en image suivant la revendication 3, dans laquelle la matière organique polymérisable par voie cationique est un époxyde ayant une fonctionnalité époxyde égale à un au moins.

5. Feuille de mise en image suivant la revendication 3, dans laquelle la matière organique contient au moins un groupe éther de vinyle.

6. Feuille de mise en image suivant l'une quelconque des revendications 1 à 5, dans laquelle ledit initiateur est un sel d'onium aromatique qui a une formule choisie entre les formules

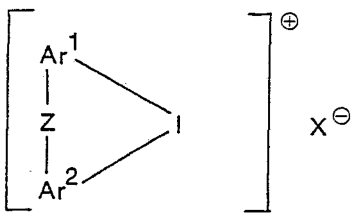

(A)

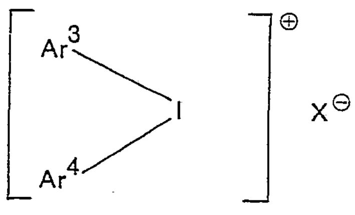

(B)

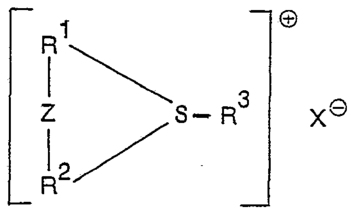

(C)

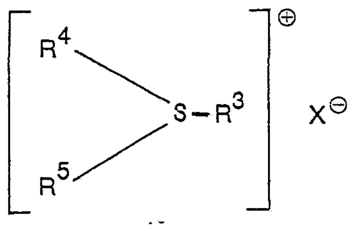

(D)

où

$Ar^1$ et $Ar^2$ représentent des groupes aromatiques divalents substitués ou non substitués égaux ou différents, qui contiennent 6 à 20 atomes de carbone;

$Ar^3$ et $Ar^4$ sont des groupes aromatiques monovalents substitués ou non substitués égaux ou différents, qui contiennent 7 à 20 atomes de carbone;

$R^1$ et $R^2$ sont choisis entre des groupes aromatiques divalents substitués et non substitués qui contiennent 6 à 20 atomes de carbone et des groupes alkylène substitués et non substitués qui contiennent 1 à 20 atomes de carbone;

$R^3$, $R^4$ et $R^5$ sont choisis chacun entre des groupes aromatiques monovalents substitués et non substitués qui contiennent 6 à 20 atomes de carbone et des groupes alkyle substitués et non substitués qui contiennent 1 à 20 atomes de carbone; sous réserve qu'au moins l'un de $R^1$, $R^2$ et $R^3$ soit aromatique dans la formule C et qu'au moins l'un de $R^3$, $R^4$ et $R^5$ soit aromatique dans la formule D;

Z est choisi dans le groupe comprenant une liaison carbone-à-carbone, l'oxygène, le soufre, un radical

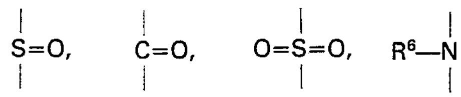

où $R^6$ est un groupe aryle ou acyle, un radical $R^7$—C—$R^8$ dans lequel $R^7$ et $R^8$ sont choisis entre l'hydrogène, des groupes alkyle qui contiennent environ 1 à 4 atomes de carbone et des groupes alcényle qui contiennent environ 2 à 4 atomes de carbone; et

X est un anion complexe contenant un halogène.

7. Feuille de mise en image suivant l'une quelconque des revendications 1 à 5, dans laquelle ledit initiateur est choisi entre

a) des composés organiques halogénés qui contiennent un halogène lié à du carbone et qui, par exposition à une radiation de longueur d'onde convenable, est dissociable avec formation de radicaux dépourvus d'halogènes, l'énergie de dissociation de la liaison carbone-à-halogène étant comprise dans l'intervalle de 167 à 293 kilojoules par mole (40 à 70 kilocalories par mole); et

b) un sel d'onium aromatique qui a l'une des formules

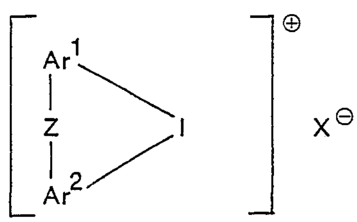

(A)

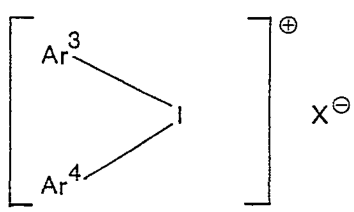

(B)

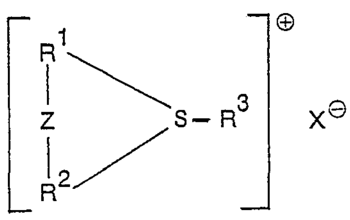

(C)

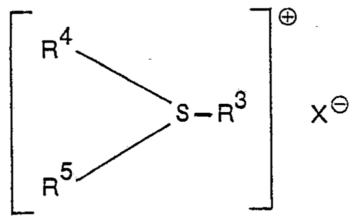

(D)

où

Ar[1] et Ar[2] représentent s groupes aromatiques divalents substitués ou non substitués égaux ou différents, qui contiennent 6 20 atomes de carbone;

Ar[3] et Ar[4] sont des g pes aromatiques monovalents substitués ou non substitués égaux ou différents, qui contiennent 6 20 atomes de carbone;

$R^1$ et $R^2$ sont choisis ·e des groupes aromatiques divalents substitués et non substitués qui contiennent 6 à 20 atomes d ırbone et des groupes alkylène substitués et non substitués qui contiennent 1 à environ 20 atomes de ca one;

$R^3$, $R^4$ et $R^5$ sont chois chacun entre des groupes aromatiques monovalents substitués et non substitués qui contiennent 6 :0 atomes de carbone et des groupes alkyle substitués et non substitués qui contiennent 1 à 20 atomes c arbone; sous réserve qu'au moins l'un de $R^1$, $R^2$ et $R^3$ soit aromatique dans la formule C et qu'au moins ın de $R^3$, $R^4$ et $R^5$ soit aromatique dans la formule D;

Z est choisi dans le grou comprenant une liaison carbone-à-carbone, l'oxygène, le soufre, un radical

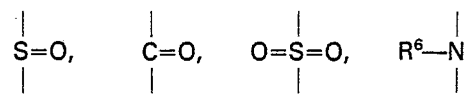

où $R^6$ est un groupe aryle ou yle, un radical $R^7$—C—$R^8$ dans lequel $R^7$ et $R^8$ sont choisis entre l'hydrogène, des groupes alkyle qui co ənnent environ 1 à 5 atomes de carbone et des groupes alcényle qui contiennent environ 2 à 4 a nes de carbone; et

X est un anion comple: contenant un halogène.

8. Feuille de mise en im ə suivant la revendication 7, dans laquelle ledit initiateur est choisi entre un hexafluorantimonate de tria sulfonium et un hexafluorarséniate de triarylsulfonium.

9. Feuille de mise en im ə suivant la revendication 1, dans laquelle ladite couche photopolymérisable comprend en outre au moin ne matière choisie entre des agents plastifiants, des agents d'adhésivité, des diluants, des colorants, des arges et des modificateurs de viscosité.

10. Procédé de product et de transfert d'une image, comprenant les étapes qui consistent

à prendre une feuille d ansfert par voie sèche ayant une feuille de couverture laissant passer une radiation activante, une cou · photopolymérisable sur la feuille de couverture et une feuille de support au contact de la couche photc lymérisable et à exposer ladite feuille de transfert par voie sèche à une radiation activante à travers feuille de couverture pour produire des régions photopolymérisées dans la feuille de transfert par voie che;

a séparer la feuille de port et la feuille de couverture de la feuille exposée de transfert par voie sèche, les régions photopol érisées de la couche photopolymérisable adhérant à la feuille de support et les régions non photopolym sées de la couche photopolymérisable adhérant à la feuille de couverture;

caractérisé par le fait qu ı) la feuille de couverture présente au moins une surface oléophile qui est au contact de la couche pho olymérisable, (b) la couche photopolymérisable comprend une matière organique polymérisable p voie cationiquee et renferme environ 0,1 à 10 parties en poids, pour 100 parties en poids de matièr rganique, d'un initiateur photopolymérisable par voie cationique et (c) la feuille de support présente ə surface oléophobe ou est au contact de la couche photopolymérisable;

caractérisé en outre par étapes d'irradiation des régions non photopolymérisées, à travers la feuille de couverture, avec une ra tion activante pendant une période suffisante pour photopolymériser au moins partiellement les rég s non photopolymérisées; et

transfert des régions moins partiellement photopolymérisées de la feuille de support à un récepteur, par application d e pression.

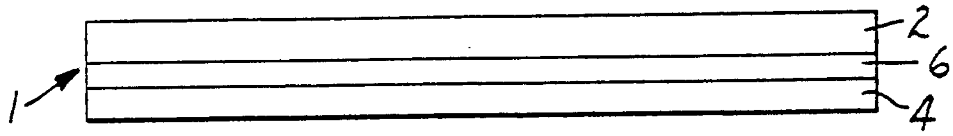


FIG. 1

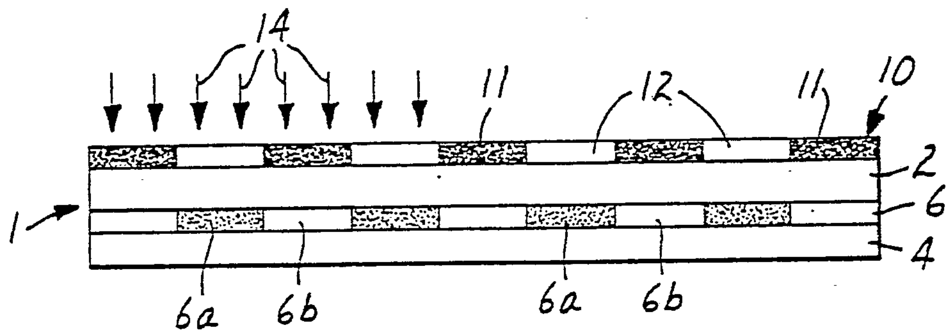


FIG. 2

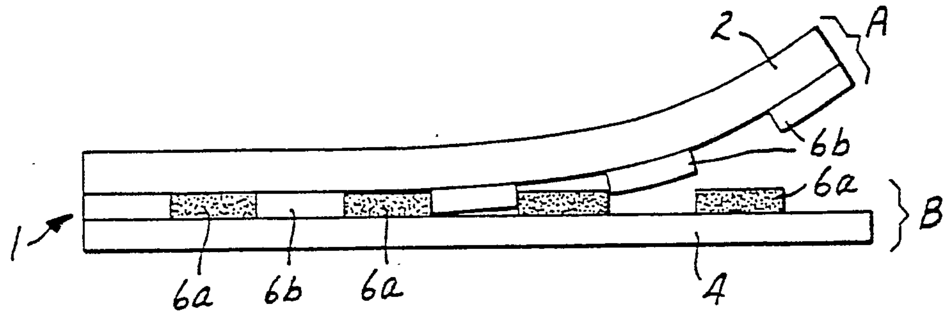


FIG. 3

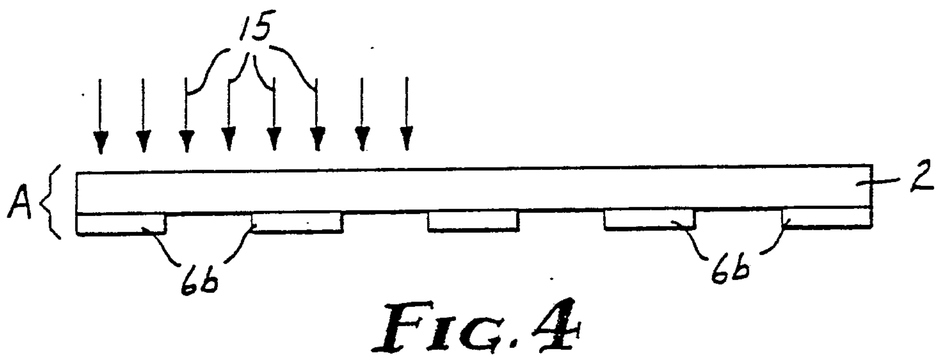


FIG. 4

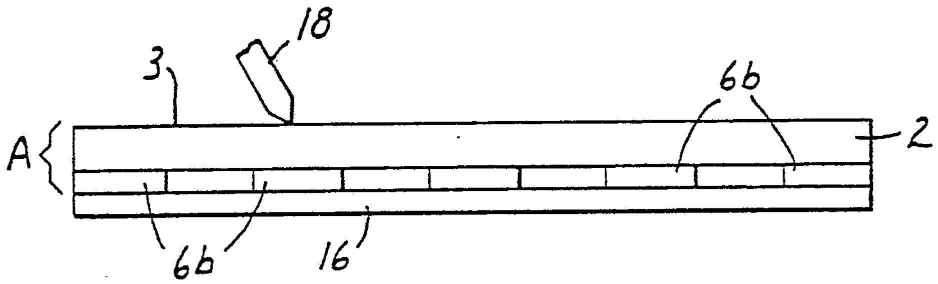


FIG. 5

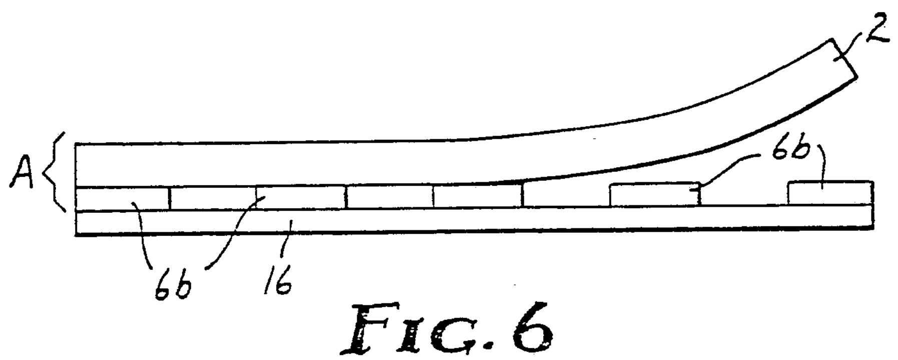


FIG. 6